# EUROPÄISCHE PATENTSCHRIFT

(11) **EP 2 960 950 B1**
(45) Veröffentlichungstag und Bekanntmachung des Hinweises auf die Patenterteilung: **25.01.2023**
(21) Anmeldenummer: 14002189.0
(22) Anmeldetag: 26.06.2014
(51) Int. Cl.: H01L 31/0687, H01L 31/041, H01L 31/0304, H01L 31/054

(54) **MEHRFACH-SOLARZELLE**
MULTIPLE SOLAR CELL
CELLULE SOLAIRE À JONCTIONS MULTIPLES

(43) Veröffentlichungstag der Anmeldung: 30.12.2015
(73) Patentinhaber: AZUR SPACE Solar Power GmbH, 74072 Heilbronn (DE)
(72) Erfinder: GUTER, Wolfgang, 70190 Stuttgart (DE); MEUSEL, Matthias, 74076 Heilbronn (DE); DIMROTH, Frank, 79115 Freiburg (DE); LACKNER, David, 79211 Denzlingen (DE)
(74) Vertreter: Koch Müller Patentanwaltsgesellschaft mbH

(56) Entgegenhaltungen:
- EP-A2- 1 109 230
- DE-A1-102012 004 734
- US-A1- 2002 195 137
- US-B1- 6 660 928
- YOUNGKUN AHN ET AL: "Numerical investigation of a hybrid-connection four-junction solar cell structure based on detailed balance calculation", RESEARCH ON CHEMICAL INTERMEDIATES, Bd. 40, Nr. 1, 7. November 2013 (2013-11-07), Seiten 77-85, XP055158213, ISSN: 0922-6168, DOI: 10.1007/s11164-013-1457-9
- SHARPS P R ET AL: "Development of 20% efficient GaInAsP solar cells", PROCEEDINGS OF THE PHOTOVOLTAIC SPECIALISTS CONFERENCE. LOUISVILLE, MAY 10 - 14, 19; [PROCEEDINGS OF THE PHOTOVOLTAIC SPECIALISTS CONFERENCE], NEW YORK, IEEE, US, vol. CONF. 23, 10 May 1993 (1993-05-10), pages 633-638, XP010113181, DOI: 10.1109/PVSC.1993.347019 ISBN: 978-0-7803-1220-3
- A.G. Foyt: "The electro-optic applications of InP", Journal of Crystal Growth, vol. 54, no. 1, 1 July 1981 (1981-07-01), pages 1-8, XP055746311, AMSTERDAM, NL ISSN: 0022-0248, DOI: 10.1016/0022-0248(81)90241-4

## Beschreibung

Die Erfindung betrifft eine Mehrfach-Solarzelle.

Aus der Druckschrift "Current-matched triple-junction solar cell reaching 41.1% conversion efficiency under concentrated sunlight" von Guter et al., Applied Physics Letters 94, 223504 (2009) ist eine Mehrfach-Solarzelle (engl. multi-junction solar cell) bekannt. Bei der offenbarten Struktur handelt es sich um eine metamorphe Ga_{0.35}In_{0.65}P/Ga_{0.83}In_{0.17}As/Ge Dreifach-Solarzelle mit hohem Wirkungsgrad. Zwischen dem Ge Substrat bzw. der Ge Teilzelle und der Ga_{0.83}In_{0.17}As Teilzelle wird ein metamorpher Puffer aus Ga_{Y}In_{1-Y}As verwendet.

Weiterhin sind aus der Druckschrift "Development of Advanced Space Solar Cells at Spectrolab" von Boisvert et al. in Proc. of 35th IEEE PVSC, Honolulu, HI, 2010, ISBN: 978-1-4244-5891-2, auf Halbleiterbond-Technologie (SBT) basierende Vierfach- bis Sechsfach-Solarzellen bekannt. Ferner ist aus der Druckschrift "Wafer bonded four-junction GaInP/GaAs//GaInAsP/GaInAs concentrator solar cells with 44.7% efficiency" von Dimroth et al. in Progr. Photovolt: Res. Appl. 2014; 22: 277-282, ein Solarzellenstapel bekannt. Aus der DE 10 2012 004 734 A1, der EP 1 109 230 A2, der US 2002/0 195 137 A1 und aus Youngkun Ahn et al: "Numerical investigation of a hybrid-connection forjunction solar cell structure based on detailed balance calculation", Research on chemical intermediates, Bd. 40, Nr. 1; 2014, Seiten 77-85, ISSN: 0922-6168 sind weitere Mehrfach-Solarzellen bekannt.

Aus P. R. Sharps et al.: "Development of 20% efficient GaInAsP Solar Cells", Proceedings of the Photovoltaic Specialists Conference, 19993, pp. 633-638, XP010113181, DOI: 10.1109/PVSC.1993.347019, ISBN: 978-0-7803-1220-3 sind GaInAsP Solarzellen bekannt.

Aus der US 6 660 928 B1 und aus A.G.Foyt: "The electro-optic applications of InP", Journal of Crystal Growth, Bd. 54, Nr. 1, Juli 1981, S. 1-8, sind GaAsInP Schichten bekannt.

Ein Problem bei Anwendung von Solarzellen zur Energieversorgung von Satelliten im Weltraum ist die Degradation des Wirkungsgrades aufgrund von Strahtung in Form von hochenergetischen Elektronen und Protonen. Die Optimierung der Strahlungshärte, insbesondere auch für sehr hohe Strahlungsdosen, ist ein wichtiges Ziel bei der Entwicklung zukünftiger Raumfahrtsolarzellen. Ziel der Solarzellenoptimierung ist nicht nur die Steigerung des ursprünglichen bzw. beginning-of-life (BOL) Wirkungsgrades sondern vor allem des Wirkungsgrades am Ende einer Mission, des so genannten end-of-life (EOL) Wirkungsgrades.

Vor diesem Hintergrund besteht die Aufgabe der Erfindung darin, eine Vorrichtung anzugeben, die den Stand der Technik weiterbildet.

Die Aufgabe wird durch eine Mehrfach-Solarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Mehrfach-Solarzelle bereitgestellt, umfassend eine erste Teilzelle, wobei die erste Teilzelle überwiegend Germanium aufweist, und wobei die Mehrfach-Solarzelle eine zweite Teilzelle aufweist, wobei die zweite Teilzelle eine größere Bandlücke als die erste Teilzelle aufweist, und jede der Teilzellen einen Emitter und eine Basis aufweist und die zweite Teilzelle eine GaInAsP-Schicht aufweist, wobei die Dicke der GaInAsP-Schicht größer als 100 nm ist und die GaInAsP-Schicht als Teil des Emitters und / oder als Teil der Basis und / oder als Teil der zwischen Emitter und Basis liegenden Raumladungszone ausgebildet ist. Es sei angemerkt, dass die GaInAsP-Schicht als eine Schicht bestehend aus einer Verbindung aus GaInAsP ausgebildet ist. Des Weiteren sei angemerkt, dass die GaInAsP-Schicht mit einer Dicke von größer 100 nm als einzelne Schicht ausgebildet ist. Weiterhin sei angemerkt, dass in der GaInAsP-Schicht eine Absorption von Photonen und hierdurch eine Generation von Ladungsträgern stattfindet, wobei die Ladungsträger zu dem Photostrom der zweiten Teilzelle beitragen. Es versteht sich, dass bei der stapelförmigen Mehrfach-Solarzelle das Sonnenlicht Immer zuerst durch die Teilzelle mit der größten Bandlücke eingestrahlt wird. Anders ausgedrückt, der Solarzellenstapel absorbiert mit der obersten Teilzelle zuerst den kurzwelligen Anteil des Lichtes. Vorliegend durchströmen die Photonen also erst die zweite Teilzelle und anschließend die erste Teilzelle.

Auch sei angemerkt, dass unter den Begriffen Emitter und Basis entweder die p-dotierten oder die n-dotierten Schichten in der jeweiligen Teilzelle verstanden werden. Auch sei angemerkt, dass unter dem Begriff überwiegend Germanium diejenigen Schichten mit einem Germanium Anteil oberhalb 95% verstanden werden. Auch sei angemerkt, dass vorliegend die chemischen Abkürzungen von Elementen synonym zu den vollständigen Begriffen verwendet werden und die Mehrfach-Solarzelle vorliegend auch nur als Solarzelle bezeichnet wird.

Ein Vorteil der Ausbildung einer ersten Teilzelle überwiegend aus Germanium, besteht darin, dass sich die erste Teilzelle einfach und kostengünstig durch Aktivierung des Germanium Substrates mittels As- und / oder P-Diffusion während des Prozesses der metallorganischen Gasphasenepitaxie (MOVPE) herstellen lässt. Insbesondere müssen für eine Ausbildung der ersten Teilzelle keine mehreren Mikrometer dicken Schichten aus Germanium, d.h. sogenannte Bulk-Schichten, zur Absorption der Photonen epitaktisch abgeschieden werden. Hierdurch weist die erste Teilzelle geringe Herstellungskosten auf. Untersuchungen haben gezeigt, dass eine Teilzelle aus Germanium eine geringe Degradation unter Bestrahlung mit 1 MeV Elektronen aufweist. Es sei angemerkt, dass unter dem Begriff Germanium Schichten, Schichten mit überwiegend Germanium verstanden werden.

Weiterhin vorteilhaft ist, wie Untersuchungen zeigten, dass die Ausbildung einer zweiten Teilzelle bestehend aus einer Verbindung aus GaInAsP bzw. zweite Teilzellen die überwiegend eine Verbindung aus GaInAsP aufweisen, je nach Komposition eine höhere Strahlungsstabilität im Vergleich zu Teilzellen aus GaAs, GaInAs, AlGaAs und / oder AlGaInAs besitzen.

Untersuchungen haben überraschend gezeigt, dass im Falle einer Ge, d.h. Germanium, basierten Mehrfach-Solarzelle die Verwendung für die zweite Teilzelle von einer Verbindung überwiegend aus GaInAsP anstelle einer Verbindung aus GaInAs aufgrund der höheren Strahlungshärte von GaInAsP gegenüber GaInAs besonders vorteilhaft ist. Bisher erschien dem Fachmann die Verwendung einer GaInAsP Zelle abwegig, denn eine zu Germanium gitterangepasst ausgebildete GaInAsP Teilzelle besitzt im Vergleich zu der bisher verwendeten GaInAs Teilzelle eine höhere Energiebandlücke. Hierdurch sinkt bei der Ausbildung einer gitterangepassten GaInP/GaInAs(P)/Ge Tripel-Solarzelle der Anfangswirkungsgrad, auch als BOL Wirkungsgrad bezeichnet, der Solarzelle. Ferner ist die Epitaxie der quaternären GaInAsP Verbindung deutlich schwieriger als die der ternären GaInAs Verbindung. Insbesondere verhält sich der Gruppe-V-Einbau nicht-linear und bei Verwendung der üblichen Wachstumsbedingungen und metallorganischen Quellen, den sogenannten Prekursoren, schwankt die Stöchiometrie stark über den Radius der Halbleiterscheibe.

Weitere Untersuchungen haben gezeigt, dass es vorteilhaft ist, möglichst wenig Aluminium in Teilzelle einzubauen. Aluminium reagiert sehr leicht auf Reaktor- oder Quellen-Verunreinigungen durch Restfeuchte und / oder Sauerstoff und verschlechtert in einer oxidierten Form die Materialqualität. Hierdurch lässt sich die Ausbeute bei der Herstellung von Mehrfachsolarzellen steigern.

Erfindungsgemäß ist eine dritte Teilzelle vorgesehen, wobei die dritte Teilzelle eine Verbindung aus GaInP und / oder AlGaInP enthält. Erfindungsgemäß weist die dritte Teilzelle einen Emitter und eine Basis auf, wobei die dritte Teilzelle eine Schicht bestehend aus einer Verbindung aus GaInP oder AlGaInP enthält, wobei die Dicke der GaInP-Schicht oder der AlGaInP-Schicht größer als 100 nm ist und die GaInP-Schicht oder die AlGaInP-Schicht als Teil des Emitters und / oder als Teil der Basis ausgebildet ist. Vorzugsweise besteht die dritte Teilzelle aus einer Verbindung von GaInP oder AlGaInP.

Ein Vorteil ist, dass Insbesondere die GaInP und / oder AlGaInP Verbindungen über eine hohe Strahlungsstabilität verfügen. Erfindungsgemäß ist zwischen der ersten Teilzelle und der zweiten Teilzelle ein metamorpher Puffer ausgebildet ist, wobei der Puffer eine Abfolge von mindestens drei Schichten aufweist und die Gitterkonstante bei der Abfolge in Richtung der zweiten Teilzelle von Schicht zu Schicht ansteigt. Ein Vorteil des metamorphen Puffers ist dass hierdurch eine größere Einstellmöglichkeit bei der Energiebandlücke der jeweiligen Teilzelle eröffnet wird, d. h. es lassen sich Einschränkungen, wie der sinkende Wirkungsgrad der Solarzelle bei der Ausbildung von besonders strahlungsharten Zellen aufgrund der bei dem steigenden Phosphor-Gehalt steigenden Energiebandlücke kompensieren oder abmildern.

In einer anderen Weiterbildung ist eine vierte Teilzelle vorgesehen, wobei die vierte Teilzelle eine Verbindung aus AIGaInAs und / oder GaInP oder GaInAsP enthält und zwischen der zweiten Teilzelle und der dritte Teilzelle angeordnet ist. Vorzugsweise enthält die vierte Teilzelle überwiegend eine Verbindung aus AlGaInAs und / oder GaInP oder GaInAsP. In einer alternativen Ausführungsform enthält die vierte Teilzelle eine Verbindung aus GaInAs und ist zwischen der ersten Teilzelle und der zweiten Teilzelle angeordnet ist. Vorzugsweise enthält die vierte Teilzelle in der alternativen Ausführungsform überwiegend eine Verbindung aus GaInAs. In einer besonders bevorzugten Ausführungsform ist ein Halbleiterspiegel ausgebildet, wobei der Halbleiterspiegel zwischen der ersten Teilzelle und der zweiten Teilzelle und / oder zwischen der ersten Teilzelle und der vierten Teilzelle angeordnet ist.

In einer anderen Ausführungsform ist die Gitterkonstante der GaInAsP-Schicht kleiner als 5,82 Å, vorzugsweise kleiner als 5,79 Å. Ferner ist es bevorzugt, die GaInAsP Schicht mit einer Dicke größer als 0,4 µm, vorzugsweise mit einer Dicke größer als 0,8 µm auszubilden. Insbesondere lässt sich mit größeren Schichtdicken die Höhe der Absorption der Photonen erhöhen.

Erfindungsgemäß ist bei der GaInAsP-Schicht der Indium-Gehalt kleiner als 50% und der Phosphor-Gehalt kleiner als 65% oder größer als 80%. In einer anderen Ausführungsform ist es bevorzugt, dass bei der GaInAsP-Schicht der Indium-Gehalt kleiner als 40% ist und / oder der Phosphor-Gehalt kleiner als 30% oder kleiner als 20% ist.

In einer anderen Ausführungsform werden sogenannte Hetero-Teilzellen, d.h. beispielsweise mit einem Emitter bestehend aus GaInP und einer Raumladungszone und / oder Basis bestehend aus GaInAs vorliegend nicht als zweite Teilzelle angesehen. In einer anderen Weiterbildung werden vorliegend zweite Teilzellen gemeint, die keine Vielfach-Quantentopf-Struktur aufweisen. Insbesondere weist die zweite Teilzelle keine Perioden aus GaInAs/GaAsP in der Raumladungszone auf.

Erfindungsgemäß weist der Solarzellenstapel keinen direkten Halbleiterbond auf, oder anders ausgedrückt, zwischen zwei beliebigen Teilzellen des Solarzellenstapels ist kein direkter Halbleiterbond ausgebildet. Anders ausgedrückt, weist der Solarzellenstapel keine amorphen Zwischenschichten und / oder keinen Sprung in der Gitterkonstante zwischen zwei stoffschlüssig aufeinanderfolgenden Schichten größer als 0,01 Ä oder 0,02 Å auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben auch keine ableitbaren geometrischen Relationen zueinander auf. Darin zeigt:
- Figur 1: einen Querschnitt auf eine Ausführungsform als Tripel-Solarzelle, die nicht Teil der beanspruchten Erfindung ist,
- Figur 2: einen Querschnitt auf eine erfindungsgemäße Ausführungsform als Tripel-Solarzelle,
- Figur 3: einen Querschnitt auf eine erfindungsgemäße Ausführungsform als Vierfach-Solarzelle mit einem metamorphen Puffer,
- Figur 4: einen Querschnitt auf eine erfindungsgemäße Ausführungsform als Vierfach-Solarzelle mit einem Halbleiterspiegel,
- Figur 5: einen Querschnitt auf eine erfindungsgemäße Ausführungsform einer Vierfach-Solarzelle mit einem Halbleiterspiegel und einem metamorphen Puffer.

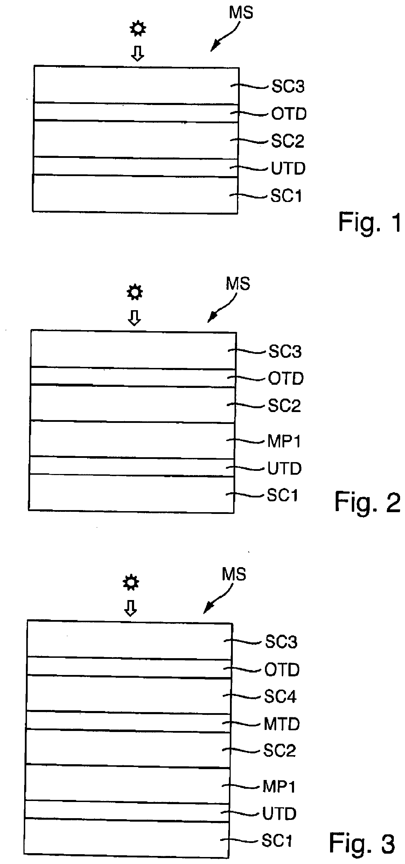

Die Abbildung der Figur 1 zeigt einen Querschnitt auf eine Ausführungsform einer stapelförmigen Mehrfach-Solarzelle MS, die nicht Teil der beanspruchten Erfindung ist, im Folgenden auch als Solarzelle bezeichnet. Die Solarzelle weist eine erste Teilzelle SC1 auf, wobei die erste Teilzelle SC1 aus Germanium besteht. Aufliegend auf der ersten Teilzelle SC1 ist eine zweite Teilzelle bestehend aus GaInAsP angeordnet. Die zweite Teilzelle SC2 weist eine größere Bandlücke als die erste Teilzelle SC1 auf. Aufliegend auf der zweiten Teilzelle SC2 ist eine dritte Teilzelle bestehend aus GaInP oder aus AlGaInP angeordnet. Zwischen der ersten Teilzelle SC1 und der zweiten Teilzelle SC2 ist eine untere Tunneldiode UTD und zwischen der zweiten Teilzelle SC2 und der dritten Teilzelle SC3 ist eine obere Tunneldiode OTD ausgebildet. Es versteht sich, dass jede der drei Teilzellen SC1, SC2 und SC3 jeweils einen Emitter und eine Basis aufweist, wobei die Dicke der zweiten Teilzelle größer als 0,4 µm ausgebildet ist.

Die Bandlücke der ersten Teilzelle SC1 ist kleiner als die Bandlücke der zweiten Teilzelle SC2. Ferner ist die Bandlücke der zweiten Teilzelle SC2 kleiner als die Bandlücke der dritten Teilzelle SC3. Es versteht sich hierdurch, dass die Sonneneinstrahlung durch die Oberfläche der dritten Teilzelle SC3 stattfindet.

Die Figur 2 zeigt einen Querschnitt auf eine erfindungsgemäße Ausführungsform in Form einer Tripel-Solarzelle. Nachfolgend werden nur die Unterschiede zu der Ausführungsform, dargestellt in Zusammenhang mit der Abbildung 1, erläutert. Zwischen der unteren Tunneldiode UTD und der zweiten Teilzelle SC2 ist ein metamorpher Puffer MP1 ausgebildet. Der Puffer MP1 besteht aus eine Vielzahl von im Einzelnen nicht dargestellten Schichten, wobei die Gitterkonstante von Schicht zu Schicht des Puffers MP1 in Richtung zu der zweiten Teilzelle SC2 erhöht. Eine Einführung des Puffers MP1 ist vorteilhaft, wenn die Gitterkonstante der zweiten Teilzelle SC3 nicht mit der Gitterkonstanten der ersten Teilzelle SC1 übereinstimmt.

In der Figur 3 ist ein Querschnitt auf eine erfindungsgemäße Ausführungsform in Form einer Vierfach-Solarzelle mit einem metamorphen Puffer MP1 dargestellt. Nachfolgend werden nur die Unterschiede zu den Ausführungsform, dargestellt in Zusammenhang mit der Abbildung 2, erläutert. Zwischen der zweiten Teilzelle SC2 und der dritten Teilzelle SC3 ist eine vierte Teilzelle SC4, bestehend aus AlGaInAs oder aus GaInP oder aus GaInAsP angeordnet. Ferner ist zwischen der zweiten Teilzelle SC2 und der vierten Teilzelle SC4 eine mittlere Tunneldiode MTD angeordnet. Ein Vorteil ist, dass bei der Ausbildung der Mehrfach-Solarzelle mit insgesamt vier Teilzellen SC1, SC2, SC3 und SC4 die Bandlücken leichter an das Sonnenspektrum anzupassen, so dass möglichst viele Photonen in der Solarzelle absorbiert werden, um den Wirkungsgrad der Solarzelle zu steigern.

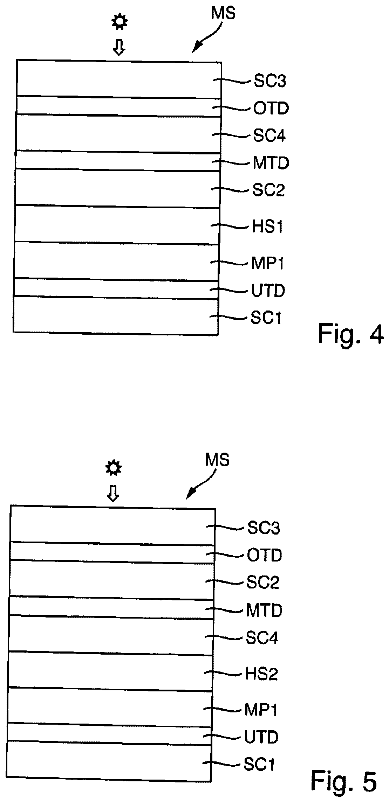

Die Figur 4 zeigt einen Querschnitt als Vierfach-Solarzelle MS mit einem Halbleiterspiegel HS. Nachfolgend werden nur die Unterschiede zu den Ausführungsform, dargestellt in Zusammenhang mit der Abbildung 3, erläutert. Zwischen der unteren Tunneldiode UTD und der zweiten Teilzelle SC2 ist ein erster Halbleiterspiegel HS1 angeordnet. Der Reflektionsverlauf des ersten Halbleiterspiegel HS1 ist auf die Bandlücke der zweiten Teilzelle SC2 abgetimt. Anders ausgedrückt, diejenigen von der zweiten Teilzelle absorbierbaren Wellenlängen werden in den Absorptionsbereich der zweiten Teilzelle SC2 zurückreflektiert. Hierdurch lässt sich die Dicke des Absorptionsbereichs der zweiten Teilzelle wesentlich verringern und die Strahlungsstabilität erhöhen.

Die Figur 5 zeigt einen Querschnitt einer Vierfach-Solarzelle MS mit einem Halbleiterspiegel HS. Nachfolgend werden nur die Unterschiede zu den Ausführungsform, dargestellt in Zusammenhang mit der Abbildung 4, erläutert. Die Lage der zweiten Teilzelle SC2 und die Lage der vierten Teilzelle SC4 sind vertauscht, so dass aufliegend auf der unteren Tunneldiode UTD nunmehr ein zweiter Halbleiterspiegel HS2 und auf dem zweiten Halbleiterspiegel HS2 aufliegend die vierte Teilzelle SC4 angeordnet. Entsprechend ist die zweite Solarzelle SC2 zwischen der mittleren Tunneldiode MTD und der oberen Tunneldiode OTD angeordnet.

## Patentansprüche

1. Stapelförmige Mehrfach-Solarzelle (MS) zur Erhöhung der Strahlungsstabilität umfassend eine erste Teilzelle (SC1), wobei die erste Teilzelle überwiegend Germanium mit einem Germanium Anteil oberhalb 95% aufweist, und
eine zweite Teilzelle (SC2), wobei die zweite Teilzelle (SC2) eine größere Bandlücke als die erste Teilzelle (SC 1) aufweist, und
jede der Teilzellen (SC1, SC2) einen Emitter und eine Basis aufweist,
wobei
die zweite Teilzelle (SC2) eine GaInAsP-Schicht aufweist und die Dicke der GaInAsP-Schicht größer als 100 nm ist und die GaInAsP-Schicht als Teil des Emitters und / oder als Teil der Basis ausgebildet ist und der Phosphor-Gehalt der GalnAsP-Schicht kleiner als 65% oder größer als 80% ist, und
- eine dritte Teilzelle (SC3) vorgesehen ist und die dritte Teilzelle (SC3) eine Schicht bestehend aus einer Verbindung aus GaInP und / oder AlGaInP enthält und die Dicke der GaInP-Schicht oder der AlGaInP-Schicht größer als 100 nm ist und die GaInP-Schicht oder die AlGaInP-Schicht als Teil des Emitters und / oder als Teil der Basis ausgebildet ist, und
- zwischen der ersten Teilzelle (SC1) und der zweiten Teilzelle (SC2) ein metamorpher Puffer (MP1) ausgebildet ist, wobei der metamorphe Puffer (MP1) eine Abfolge von mindestens drei Schichten aufweist und die Gitterkonstante bei der Abfolge in Richtung der zweiten Teilzelle (SC2) von Schicht zu Schicht ansteigt, und
- zwischen zwei beliebigen Teilzellen kein direkter Halbleiterbond ausgebildet ist, und
der Indium-Gehalt der GaInAsP-Schicht kleiner als 50% ist.

2. Mehrfach-Solarzelle (MS) nach Anspruch 1, **dadurch gekennzeichnet, dass** eine vierte Teilzelle (SC4) vorgesehen ist und die vierte Teilzelle (SC4) eine Verbindung aus AlGaInAs und / oder GaInP oder GaInAsP enthält und zwischen der zweiten Teilzelle (SC2) und der dritten Teilzelle (SC3) angeordnet ist oder die vierte Teilzelle (SC4) eine Verbindung aus GaInAs enthält und zwischen der ersten Teilzelle (SC1) und der zweiten Teilzelle (SC2) angeordnet ist.

3. Mehrfach-Solarzelle (MS) nach Anspruch 2, **dadurch gekennzeichnet, dass** ein Halbleiterspiegel (HS1) ausgebildet ist und der Halbleiterspiegel (HS1) zwischen der ersten Teilzelle (SC1) und der zweiten Teilzelle (SC2) und / oder zwischen der ersten Teilzelle (SC1) und der vierten Teilzelle (SC4) angeordnet ist.

4. Mehrfach-Solarzelle (MS) nach einem der vorangegangenen Ansprüche, **dadurch gekennzeichnet, dass** die Gitterkonstante der GaInAsP-Schicht kleiner als 5,82 Ä ist oder kleiner als 5,79 Ä ist.

5. Mehrfach-Solarzelle (MS) nach einem der vorangegangenen Ansprüche, **dadurch gekennzeichnet, dass** die GaInAsP Schicht eine Dicke größer als 0,4 µm oder größer als 0,8 µm aufweist.

6. Mehrfach-Solarzelle (MS) nach einem der vorangegangenen Ansprüche, **dadurch gekennzeichnet, dass** bei der GaInAsP-Schicht der Phosphor-Gehalt kleiner als 40% ist.

7. Mehrfach-Solarzelle (MS) nach einem der vorangegangenen Ansprüche, **dadurch gekennzeichnet, dass** bei der GaInAsP-Schicht der Indium-Gehalt kleiner als 40% ist und / oder der Phosphor-Gehalt kleiner als 30% ist oder kleiner als 20% ist.

8. Mehrfach-Solarzelle (MS) nach einem der vorangegangenen Ansprüche, **dadurch gekennzeichnet, dass** die zweite Teilzelle (SC2) keine Vielfach-Quantentopf-Struktur aufweist.

9. Mehrfach-Solarzelle (MS) nach einem der vorangegangenen Ansprüche, **dadurch gekennzeichnet, dass** zwischen der ersten Teilzelle (SC1) und der zweiten Teilzelle (SC2) eine untere Tunneldiode (UTD) ausgebildet ist.

10. Mehrfach-Solarzelle (MS) nach Anspruch 9, **dadurch gekennzeichnet, dass** der metamorphe Puffer (MP1) zwischen der unteren Tunneldiode (UTD) und der zweiten Teilzelle (SC2) ausgebildet ist.

11. Mehrfach-Solarzelle (MS) nach Anspruch 9 oder Anspruch 10, **dadurch gekennzeichnet, dass** der Halbleiterspiegel (HS1) zwischen der unteren Tunneldiode (UTD) und der zweiten Teilzelle (SC2) angeordnet ist.

## Claims

1. Stack-shaped multiple solar cell (MS) for increasing radiation stability, comprising
a first part cell (SC1), wherein the first part cell predominantly comprises germanium with a germanium component above 95%, and
a second part cell (SC2), wherein the second part cell (SC2) has a greater band gap than the first part cell (SC1), and
each of the part cells (SC1, SC2) has an emitter and a base,
- wherein the second part cell (SC2) comprises a GaInAsP layer and the thickness of the GaInAsP layer is greater than 100 nm and the GaInAsP layer is formed as part of the emitter and/or as part of the base and the phosphorus content of the GaInAsP layer is smaller than 65% or larger than 80%, and
- a third part cell (SC3) is provided and the third part cell (SC3) contains a layer consisting of a compound of GaInP and/or AlGaInP and the thickness of the GaInP layer or the AlGaInP layer is larger than 100 nm and the GaInP layer or the AlGaInP layer is formed as part of the emitter and/or as part of the base, and
- a metamorphic buffer (MP1) is formed between the first part cell (SC1) and the second part cell (SC2), wherein the metamorphic buffer (MP1) comprises a sequence of at least three layers and the lattice constant in the case of the sequence in the direction of the second part cell (SC2) increases from layer to layer, and
- no direct semiconductor bond is formed between any two part cells and
the indium content of the GaInAsP layer is smaller than 50%.

2. Multiple solar cell (MS) according to claim 1, **characterised in that** a fourth part cell (SC4) is provided and the fourth part cell (SC4) contains a compound of AlGaInAs and/or GaInP or GaInAsP and is arranged between the second part cell (SC2) and the third part cell (SC3) or the fourth part cell (SC4) contains a compound of GaInAs and is arranged between the first part cell (SC1) and the second part cell (SC2).

3. Multiple solar cell (MS) according to claim 2, **characterised in that** a semiconductor mirror (HS1) is formed and the semiconductor mirror (HS1) is arranged between the first part cell (SC1) and the second part cell (SC2) and/or between the first part cell (SC1) and the fourth part cell (SC4).

4. Multiple solar cell (MS) according to any one of the preceding claims, **characterised in that** the lattice constant of the GaInAsP layer is smaller than 5.82 Å or smaller than 5.79 Å.

5. Multiple solar cell (MS) according to any one of the preceding claims, **characterised in that** the GaInAsP layer has a thickness greater than 0.4 µm or greater than 0.8 µm.

6. Multiple solar cell (MS) according to any one of the preceding claims, **characterised in that** in the case of the GaInAsP layer the phosphorus content is smaller than 40%.

7. Multiple solar cell (MS) according to any one of the preceding claims, **characterised in that** in the case of the GaInAsP layer the indium content is smaller than 40% and/or the phosphorus content is smaller than 30% or smaller than 20%.

8. Multiple solar cell (MS) according to any one of the preceding claims, **characterised in that** the second part cell (SC2) does not have a multiple quantum well structure.

9. Multiple solar cell (MS) according to any one of the preceding claims, **characterised in that** a lower tunnel diode (UTD) is formed between the first part cell (SC1) and the second part cell (SC2).

10. Multiple solar cell (MS) according to claim 9, **characterised in that** the metamorphic buffer (MP1) is formed between the lower tunnel diode (UTD) and the second part cell (SC2).

11. Multiple solar cell (MS) according to claim 9 or claim 10, **characterised in that** the semiconductor mirror (HS1) is arranged between the lower tunnel diode (UTD) and the second part cell (SC2).

## Revendications

1. Cellule solaire à jonctions multiples (MS) en forme de pile pour augmenter la stabilité aux radiations comprenant une première sous-cellule (SC1), laquelle première sous-cellule contient essentiellement du germanium avec une teneur en germanium supérieure à 95%, et une deuxième sous-cellule (SC2), laquelle deuxième sous-cellule présente une plus grande bande interdite que la première sous-cellule (SC1), et chacune des parties de cellule (SC1, SC2) comporte un émetteur et une base,
- dans laquelle la deuxième sous-cellule (SC2) comporte une couche de GaInAsP et l'épaisseur de la couche de GalnAsP est supérieure à 100 nm et la couche de GalnAsP est configurée comme une partie de l'émetteur et/ou comme une partie de la base et la teneur en phosphore de la couche de GaInAsP est inférieure à 65% ou supérieure à 80%,
- une troisième sous-cellule (SC3) est prévue et cette troisième sous-cellule (SC3) contient une couche constituée d'un composé de GalnP et/ou d'AlGalnP et l'épaisseur de la couche de GaInP ou d'AIGaInP est supérieure à 100 nm et la couche de GalnP ou la couche d'AlGaInP est configurée comme une partie de l'émetteur et/ou comme une partie de la base,
- un tampon métamorphique (MP1) est formé entre la première sous-cellule (SC1) et la deuxième sous-cellule (SC2), lequel tampon métamorphique (MP1) présente une succession d'au moins trois couches et, dans cette succession, la constante de réseau augmente de couche en couche en direction de la deuxième sous-cellule (SC2), et
- aucune liaison conductrice directe n'est établie entre deux sous-cellules quelconques et la teneur en indium de la couche de GalnAsP est inférieure à 50%.

2. Cellule solaire à jonctions multiples (MS) selon la revendication 1, **caractérisée en ce qu'**une quatrième sous-cellule (SC4) est prévue et que cette quatrième sous-cellule (SC4) contient un composé d'AIGaInAs et/ou de GalnP ou de GaInAsP et est agencée entre la deuxième sous-cellule (SC2) et la troisième sous- cellule (SC3) ou que cette quatrième sous-cellule (SC4) contient un composé de GaInAs et est agencée entre la première sous-cellule (SC1) et la deuxième sous-cellule (SC3)

3. Cellule solaire à jonctions multiples (MS) selon la revendication 2, **caractérisée en ce qu'**un miroir semi-conducteur (HS1) est formé et que ce miroir semi-conducteur (HS1) est agencé entre la première sous-cellule (SC1) et la deuxième sous-cellule (SC2) et/ou entre la première sous-cellule (SC1) et la quatrième sous-cellule (SC4).

4. Cellule solaire à jonctions multiples (MS) selon une des revendications précédentes, **caractérisée en ce que** la constante de réseau de la couche de GaInAsP est inférieure à 5,82 Å ou inférieure à 5,79 Å.

5. Cellule solaire à jonctions multiples (MS) selon une des revendications précédentes, **caractérisée en ce que** la couche de GaInAsP présente une épaisseur supérieure à 0,4 µm ou supérieure à 0,8 µm.

6. Cellule solaire à jonctions multiples (MS) selon une des revendications précédentes, **caractérisée en ce que**, dans la de GaInAsP, la teneur en phosphore est inférieure à 40%.

7. Cellule solaire à jonctions multiples (MS) selon une des revendications précédentes, **caractérisée en ce que**, dans la de GalnAsP, la teneur en indium est inférieure à 40% et/ou la teneur en phosphore est inférieure à 30% ou inférieure à 20%.

8. Cellule solaire à jonctions multiples (MS) selon une des revendications précédentes, **caractérisée en ce que** la deuxième sous-cellule (SC2) ne présente pas de structure à puits quantiques multiples.

9. Cellule solaire à jonctions multiples (MS) selon une des revendications précédentes, **caractérisée en ce qu'**entre la première sous-cellule (SC1) et la deuxième sous-cellule (SC2), une diode tunnel inférieure (UTD) est formée.

10. Cellule solaire à jonctions multiples (MS) selon la revendication 9, **caractérisée en ce que** le tampon métamorphique (MP1) est formé entre la diode tunnel inférieure (UTD) et la deuxième cellule partielle (SC2).

11. Cellule solaire à jonctions multiples (MS) selon la revendication 9, **caractérisée en ce que** le miroir semi-conducteur (HS1) est agencé entre la diode tunnel inférieure (UTD) et la deuxième cellule partielle (SC2).
